# EUROPÄISCHE PATENTSCHRIFT

(11) **EP 0 508 286 B1**
(45) Veröffentlichungstag und Bekanntmachung des Hinweises auf die Patenterteilung: **27.09.1995**
(21) Anmeldenummer: 92105582.8
(22) Anmeldetag: 01.04.1992
(51) Int. Cl.: H05K 5/06, H05K 7/00

(54) **Gehäuse für den Einbau in Kraftfahrzeuge zur Aufnahme von Elektronikbauteilen**
Housing for installation in motor vehicles for retaining electronic components
Boîtier à intégrer dans des véhicules destiné à recevoir des composants électroniques

(30) Priorität: 12.04.1991 DE 4112022
(43) Veröffentlichungstag der Anmeldung: 14.10.1992
(73) Patentinhaber: TEMIC TELEFUNKEN microelectronic GmbH, 74072 Heilbronn (DE)
(72) Erfinder: Schirmer, Klaus, W-8070 Ingolstadt (DE)
(74) Vertreter: Maute, Hans-Jürgen, Dipl.-Ing.

(56) Entgegenhaltungen:
- EP-A- 0 113 073
- DE-A- 3 602 245
- DE-B- 2 347 250

## Beschreibung

Die Erfindung betrifft ein Gehäuse für den Einbau in Kraftfahrzeuge zur Aufnahme von Elektronikbauteilen, wobei die Elektronikbauteile auf einem Elektronikträger, insbesondere Leiterplatte, Folie oder Hybridträger, angeordnet sind.

Zunehmend werden in Kraftfahrzeugen elektronische Steuer- und Regelsysteme eingesetzt, deren Baugruppen in Gehäusen untergebracht sind, die sie vor den im Betrieb auftretenden Belastungen und Störungen ausreichend schützen. Hierbei sind solche Gehäuse teilweise oder vollständig als Metallgehäuse ausgeführt, um elektromagnetische Störungen (EMV-Störungen) zu unterdrücken. Gleichzeitig dient ein solches Metallgehäuse zur Wärmeabfuhr der elektrischen Verlustleistung, wobei dies bei einer Umgebungstemperatur von -40 °C bis 125 °C beispielsweise durch zusätzliche Verwendung von Kühlrippen sichergestellt werden kann.

Diese Anforderung bezüglich der Temperaturbeständigkeit, insbesondere bei thermischer Schockbelastung zusammen mit der Forderung, daß das Gehäuse dicht ist, auch gegenüber Hochdruckdampfstrahl-Reinigungsgeräten, macht das gesamte Gehäuse motorraumtauglich. Solche wasserdichten Gehäuse, die auch mechanischen Schockbelastungen unterzogen werden, werden meist aus Aluminiumdruckguß mit Druckausgleichspille in Leiterplattentechnik oder als hermetisch verschlossener Hybrid hergestellt. Die Kosten für eine derartige Verpackung der Elektronik liegen in vielen Fällen bei ca. 30 Prozent der Gesamtkosten.

Das Dokument EP-A-0 113 073 offenbart ein Gehäuse für den Einbau in Kraftfahrzeuge zur Aufnahme von Elektronikbauteilen, wobei die Elektronikbauteile auf einem Elektronikträger angeordnet und von einer wasserdichten Folie abgedeckt sind.

Die Aufgabe der Erfindung besteht daher darin, ein dichtes Gehäuse der eingangs genannten Art zu schaffen, das einen einfachen Aufbau aufweist und eine einfache Fertigung zu geringen Kosten erlaubt, sowie einen zuverlässigen Schutz der Elektronik gewährleistet.

Die Aufgabe wird gemäß den kennzeichnenden Merkmalen des Patentanspruches 1 gelöst.

Das Wesen der Erfindung besteht darin, die auf dem Elektronikträger montierten und mit einem Schutzlack versehenen Elektronikbauteile mittels einer luftdichten und flexiblen Folie abzuschließen, wobei sich diese Folie als Tiefziehteil der Kontur der Bauelemente weitgehend anpaßt. Die Flexibilität der Folie garantiert, daß sie die von dem eingeschlossenen Luftvolumen über dem Temperaturbereich bei konstantem Luftdruck durchgemachte Volumenänderungen mitmacht, so daß die Dichtstellen, gebildet von dem mit der Folie luft- und wasserdicht verbundenen, den Elektronikträger umlaufenden Rand der Metallplatte, nicht so belastet werden, daß Undichtigkeiten auftreten.

Da diese Folie, vorzugsweise aus Kunststoff nicht als mechanischer Schutz dient, sondern nur gegen Feuchtigkeit schützen kann, ist ein Gehäusedeckel vorgesehen, der zusammen mit der Metallplatte das Gehäuse bildet.

Gemäß einer vorteilhaften Weiterbildung der Erfindung kann als Folie auch eine beidseitig kunststoffbeschichtete Aluminiumfolie verwendet werden, die zusätzliche Vorteile im Bereich der Abschirmung gegen elektromagnetische Felder (EMV-Schutz) bieten kann.

Ferner kann bei einer weiteren bevorzugten Ausführungsform der Erfindung die Folie mit Einprägungen, wie es bei Barometerdosen vorzufinden ist versehen werden, um eine bessere Anpassung der Folie an das sich bei Temperaturänderungen ändernde Volumen des von der Folie eingeschlossenen Luftraumes zu erreichen.

Der auf die Oberfläche der Elektronikbauelemente sowie des Elektronikträgers aufgebrachte Schutzlack verhindert bei Betauung aus dem darüber befindlichen, von der Folie eingeschlossenen geringen Luftvolumen elektrische Störungen. Gemäß einer Weiterbildung der Erfindung kann als Schutzlack ein UV-härtender Lack oder ein Polyurethanlack vorgesehen werden.

Schließlich kann der Gehäusedeckel so ausgeführt sein, daß er auf die Metallplatte aufgeklipst werden kann, wodurch ein besonders einfacher Montageablauf durchführbar ist. Vorzugsweise kann der Gehäusedeckel als Kunststoffspritzgußteil gefertigt sein.

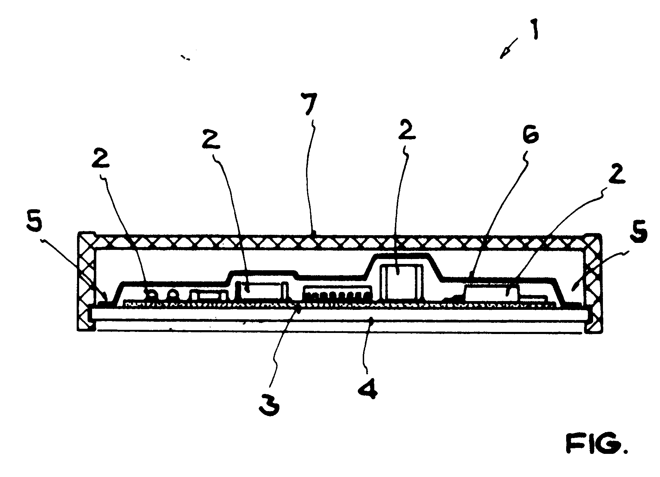

Im folgenden soll die Erfindung anhand eines Ausführungsbeispieles im Zusammenhang mit der Zeichnung dargestellt und erläutert werden. Die Figur zeigt eine Querschnittsansicht eines Ausführungsbeispieles der Erfindung.

Das Gehäuse 1 nach der Figur umfaßt eine Metallplatte 4, beispielsweise aus Aluminium, auf der ein die Elektronikbauteile 2 tragender Elektronikträger - hier eine Leiterplatte - aufgeklebt ist. Diese Leiterplatte 3 ist also mit diesen Elektronikbauteilen, die verschiedene Höhen und Größen aufweisen, bestückt. Weiterhin ist die flächige Ausdehnung dieser Leiterplatte 3 kleiner als diejenige der Metallplatte 4, so daß von dieser Metallplatte 4 ein die Leiterplatte 3 umlaufender Rand 5 gebildet wird. Bevor eine Folie 6 über die Anordnung aus der Trägerplatte 3 und der Metallplatte 4 aufgezogen wird, wird die Leiterplatte 3 mit den Elektronikbauteilen 2 mit einem Schutzlack beschichtet, wodurch bei Betauung aus dem darüber befindlichen eingeschlossenen Luftraum elektrische Störungen verhindert werden. Die an die Kontur der Elektronikbauelemente 2 weitgehend angepaßte Folie 6 ist auf den umlaufenden Rand 5 der Metallplatte 4 luft- und wasserdicht aufgeklebt. Diese Folie 6, beispielsweise eine Kunststofffolie mit einer Dicke von 50 - 150 µm wird in einem Tiefziehverfahren aufgebracht, wobei darauf geachtet wird, daß das eingeschlossene Luftvolumen so gering wie möglich gehalten wird. Da das von dieser Folie eingeschlossene Luftvolumen über dem Temperaturbereich bei konstantem Druck eine Volumenänderung bis zu 30 Prozent durchmacht, garantiert die Flexibilität dieser Folie 6, daß diese Volumenänderungen von ihr mitgemacht werden können, da sonst der erhöhte Luftdruck zu einer Undichtigkeit führen könnte. Einprägungen in Form einer Barometerdose in diese Folie 6 erleichtern deren kräftearme Volumenänderung.

Alternativ zu einer Kunststofffolie kann auch eine beidseitig kunststoffbeschichtete Aluminiumfolie verwendet werden, die zusätzliche Vorteile im Bereich der Abschirmung gegen elektromagnetische Felder bieten kann.

Diese Folie 6 stellt somit eine luftdichte, allerdings weiche Abdeckung dar und bietet einen Schutz gegen Feuchtigkeit. Ein mechanischer Schutz der Anordnung wird durch einen haubenförmigen Deckel 7 gewährleistet, der über die Leiterplatte 3 gestülpt und auf die Metallplatte 4 aufgeklipst wird. Somit wird eine definierte und technisch akzeptable Außenkontur des Gehäuses 1 sichergestellt. Dieser Gehäusedeckel 7 kann kostengünstig als Kunststoffspritzgußteil hergestellt werden, das gegebenenfalls auch Anschraubpositionen aufweisen kann.

Der Aufbau dieses erfindungsgemäßen Gehäuses ermöglicht zu dessen Montage einen einfachen Ablauf in einer automatischen Fertigungsstraße zu geringen Kosten und zuverlässigem Schutz der Elektronik auch in Hochtemperaturanwendungen. Solche Hochtemperaturanwendungen treten insbesondere dann auf, wenn elektronische Baugruppen direkt am Motorblock eines Kraftfahrzeuges angeordnet werden müssen.

## Patentansprüche

1. Gehäuse (1) für den Einbau in Kraftfahrzeuge zur Aufnahme von Elektronikbauteilen (2), wobei die Elektronikbauteile (2) auf einem Elektronikträger (3), insbesondere Leiterplatte, Folie oder Hybridträger, angeordnet und sind, von einer wasserdichten Folie abgedeckt
- worin eine Metallplatte (4) als Träger für den Elektronikträger (3) vorgesehen ist, wobei zur Bildung eines den Elektronikträger (3) umlaufenden Randes (5) diese Metallplatte (4) in ihrer flächenhaften Ausdehnung größer als der Elektronikträger (3) ist, und als mechanischer Schutz ein Gehäusedeckel (7) vorgesehen ist, der zusammen mit der Metallplatte (4) das Gehäuse (1) bildet, dadurch gekennzeichnet,
- daß die Oberfläche des mit den Elektronikbauteilen (2) versehenen Elektronikträgers (3) und die Elektronikbauteile mit einem Schutzlack beschichtet sind, und
- daß zum Schutz gegen Feuchtigkeit eine flexible, luftdichte und wasserdichte Folie (6) derart auf die Anordnung aus Metallplatte (4) und mit den Elektronikbauteilen (2) versehenen Elektronikträger (3) aufgebracht wird, daß die Folie (6) mit dem umlaufenden Rand (5) luft- und wasserdicht verbunden ist und die Folie (6) der Oberflächenkontur der Elektronikbauteile (2) weitgehend angepaßt ist.

2. Gehäuse nach Anspruch 1, dadurch gekennzeichnet, daß als Folie (6) eine Kunststoffolie Verwendung findet.

3. Gehäuse nach Anspruch 1, dadurch gekennzeichnet, daß als Folie (6) eine beidseitig kunststoffbeschichtete Metallfolie Verwendung findet.

4. Gehäuse nach Anspruch 4, dadurch gekennzeichnet, daß die Metallfolie aus Aluminium besteht.

5. Gehäuse nach einem der vorhergehenden Ansprüche, dadurch gekennzeichnet, daß zur besseren Anpassung der Folie (6) an das sich bei Temperaturänderung sich ändernde Volumen des von der Folie (6) eingeschlossenen Luftraumes diese Folie (6) Einprägungen aufweist.

6. Gehäuse nach einem der vorhergehenden Ansprüche, dadurch gekennzeichnet, daß als Schutzlack ein UV-härtender Lack vorgesehen ist.

7. Gehäuse nach einem der Ansprüche 1 bis 5, dadurch gekennzeichnet, daß als Schutzlack ein Polyurethanlack vorgesehen ist.

8. Gehäuse nach einem der vorhergehenden Ansprüche, dadurch gekennzeichnet, daß der Gehäusedeckel (7) so ausgebildet ist, daß er auf die Metallplatte (4) aufgeklipst werden kann.

9. Gehäuse nach einem der vorhergehenden Ansprüche, dadurch gekennzeichnet, daß der Gehäusedeckel (7) als Kunststoffspritzgußteil gefertigt ist.

## Claims

1. Housing (1) for installation in motor vehicles to receive electronic components (2), wherein the electronic components (2) are disposed on an electronics support (3), particularly a circuit board, film or hybrid support, and are covered by a water-tight film,
- wherein a metal plate (4) is provided as support for the electronics support (3), this metal plate (4) being greater than the electronics support (3) in the extent of its surface in order to form a rim (5) of this metal plate (4) running around the electronics support (3), and as mechanical protection a housing cover (7) is provided which together with the metal plate (4) forms the housing (1), characterised in that
- the surface of the electronics support (3) which is provided with the electronic components (2) and the electronic components themselves are coated with a protective varnish, and
- for protection against moisture a flexible, airtight and water-tight film (6) is applied to the arrangement of metal plate (4) and electronics support (3) provided with the electronic components (2) in such a way that the film is connected to the peripheral rim (5) so as to be air- and water-tight and the film (6) is largely adapted to the surface contour of the electronics components (2).

2. Housing according to Claim 1, characterised in that a film of plastics material is used as the film (6).

3. Housing according to Claim 1, characterised in that a metal foil coated on both sides with plastics material is used as the film (6).

4. Housing according to Claim 4, characterised in that the metal foil is made from aluminium.

5. Housing according to one of the preceding claims, characterised in that for better adaptation of the film (6) to the volume of the air space which is enclosed by the film (6) and varies with a change in temperature this film (6) has impressions.

6. Housing according to one of the preceding claims, characterised in that a UV-hardening varnish is provided as the protective varnish.

7. Housing according to one of Claims 1 to 5, characterised in that a polyurethane varnish is provided as the protective varnish.

8. Housing according to one of the preceding Claims, characterised in that the housing cover (7) is constructed so that it can be clipped onto the metal plate (4).

9. Housing according to one of the preceding claims, characterised in that the housing cover (7) is produced as an injection moulded plastics part.

## Revendications

1. Boîtier (1) récepteur de composants électroniques (2) pour montage dans des véhicules automobiles, dans lequel les composants électroniques (2) sont disposés sur un support appelé porte-électronique (3), constitué en particulier par une plaquette de circuits imprimés, une feuille ou un support hybride, et sont recouverts d'une feuille étanche à l'eau,
- dans lequel une plaque métallique (4) est prévue comme support pour le porte-électronique (3), la plaque (4) ayant une étendue superficielle plus grande que le porte-électronique (3) en vue de la formation d'un bord (5) autour du porte-électronique (3), et avec prévision, comme protection mécanique, d'un couvercle (7) qui forme ensemble avec la plaque métallique (4) le boîtier (1), caractérisé en ce
- que la surface du porte-électronique (3) pourvu des composants électroniques (2) et la surface des composants électroniques sont revêtues d'un vernis protecteur et
- que, pour la protection contre l'humidité, une feuille souple (6), qui est étanche à l'air et à l'eau, est appliquée sur le dispositif composé de la plaque métallique (4) et du porte-électronique (3) pourvu des composants électroniques (2), de manière que la feuille (6) soit reliée de façon étanche à l'air et à l'eau au bord périphérique (5) et que la feuille (6) soit largement adaptée au contour superficiel des composants électroniques (2).

2. Boîtier selon la revendication 1, caractérisé en ce que la feuille (6) est une feuille de matière plastique.

3. Boîtier selon la revendication 1, caractérisé en ce que la feuille (6) est une feuille métallique revêtue des deux côtés de matière plastique.

4. Boîtier selon la revendication 3, caractérisé en ce que la feuille métallique est en aluminium.

5. Boîtier selon une des revendications précédentes, caractérisé en ce que la feuille (6) présente des empreintes afin qu'elle s'adapte mieux au volume, qui change lors de variations de température, de l'espace d'air enfermé par la feuille (6).

6. Boîtier selon une des revendications précédentes, caractérisé en ce que le vernis protecteur est un vernis durcissant aux rayons ultraviolets.

7. Boîtier selon une des revendications 1 à 5, caractérisé en ce que le vernis protecteur est un vernis de polyuréthanne.

8. Boîtier selon une des revendications précédentes, caractérisé en ce que le couvercle (7) du boîtier est réalisé de manière qu'il puisse être encliqueté sur la plaque métallique (4).

9. Boîtier selon une des revendications précédentes, caractérisé en ce que le couvercle du boîtier (7) est une pièce moulée par injection en matière plastique.
